Europäisches Patentamt

European Patent Office (11) Publication number: **0 009 978**

Office européen des brevets **B1**

(19)

(12) **EUROPEAN PATENT SPECIFICATION**

(45) Date of publication of patent specification: **18.04.84**   (51) Int. Cl.³: **H 01 L 23/36**

(21) Application number: **79302112.2**

(22) Date of filing: **04.10.79**

(54) Hybrid Type integrated circuit device.

<table>
<tr><td>

(30) Priority: **06.10.78 JP 122536/78**

(43) Date of publication of application:<br>**16.04.80 Bulletin 80/8**

(45) Publication of the grant of the patent:<br>**18.04.84 Bulletin 84/16**

(84) Designated Contracting States:<br>**DE GB NL SE**

(56) References cited:<br>**DE - A - 2 824 250**<br>**DE - B - 1 539 638**<br>**DE - B - 1 564 945**<br>**US - A - 2 887 628**<br>**US - A - 3 969 754**

</td><td>

(73) Proprietor: **Hitachi, Ltd.**<br>**5-1, Marunouchi 1-chome**<br>**Chiyoda-ku Tokyo 100 (JP)**

(72) Inventor: **Kuniya, Keiichi**<br>**24-10, Nishinarusawacho-1-chome**<br>**Hitachi-shi (JP)**<br>Inventor: **Arakawa, Hideo**<br>**2656-92, Kanesawacho**<br>**Hitachi-shi (JP)**<br>Inventor: **Namekawa, Takashi**<br>**5-7, Kaminecho-4-chome**<br>**Hitachi-shi (JP)**<br>Inventor: **Ohashi, Masabumi**<br>**9-13, Chikokucho-3-chome**<br>**Hitachi-shi (JP)**<br>Inventor: **Asahi, Naotatsu**<br>**3-16-19, Higashioshima**<br>**Katsuta-shi (JP)**<br>Inventor: **Ogawa, Takuzo**<br>**406-22, Minamikoyacho**<br>**Hitachi-shi (JP)**

(74) Representative: **Paget, Hugh Charles Edward et al,**<br>**MEWBURN ELLIS & CO. 2/3 Cursitor Street**<br>**London EC4A 1BQ (GB)**

</td></tr>
</table>

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

Hybrid type integrated circuit device

This invention relates generally to a hybrid type integrated circuit devices and more particularly to a hybrid type integrated circuit devices with circuit elements which generate a large amount of heat.

A recent development of semiconductor technology has been to develop not only a power module in which large-capacity thyristors, transistors and the like, along with their driver circuit elements, are arranged on a single substrate but also a hybrid IC in which a plurality of circuit elements are arranged on a single substrate.

The integrated circuit device of the type mentioned above usually comprises a metal heat sink, an insulating layer disposed on the metal heat sink, a number of conductor films for forming a desired circuit network on the insulating layer, and semiconductor elements and the like circuit elements connected between the conductor films. The heat sink and the conductor film are made of electrically conductive materials. In general, copper is used for the heat sink and aluminum, copper or silver is widely used for the conductor film. It is the practice that the insulating layer is made of alumina and, when incorporating the insulating layer into the device, an alumina plate with one surface metallized is placed on the heat sink and bonded thereto by soldering.

In hybrid type integrated circuit device, heat generated in the circuit elements during its operation is transferred to the insulating layer and then dissipated from the heat sink. To obtain better heat dissipation characteristics, in some applications, a heat sink is used having its surface coated with nickel and an insulating layer is used with its surface facing the heat sink coated with copper, see US—A—3,469,148, for example. The construction of this prior art device was, however, insufficient to dissipate heat generated in circuit elements. Therefore, this prior art device is somewhat troublesome because of the poor dissipation of heat generated in the circuit elements. This tendency is aggravated especially when semiconductor element which generate a large amount of heat are used as the circuit elements.

When the semiconductor elements used as the circuit elements are overheated, this resulting in increase in leakage current of the semiconductor elements and decrease in blocking voltage of the same.

Therefore, it is highly desirable to dissipate effectively heat generated in the circuit elements in order to suppress degradation in performance of the integrated circuit device.

One reason for the insufficient heat dissipation characteristics of the prior art integrated circuit device is such that the thickness of the insulating layer typically amounting up to 500 to 800 $\mu$m is too great. If the insulating layer could be reduced to the order of thickness of 200 to 300 $\mu$m, the heat dissipation characteristics would be improved considerably.

If the thickness of the insulating layer is reduced to meet the heat dissipation characteristics, however, additional problems arise in that the insulating layer will warp owing to thermal distortion due to heat generated in the circuit elements during current conduction and, in extremity, it will break. This is because the thermal expansion coefficients of the insulating layer and the heat sink are very different. For example, while alumina generally used for the insulating layer has a coefficient of linear expansion of about $6.3 \times 10^{-6}/°C$, copper generally used for the heat sink has a coefficient of linear expansion of about $17 \times 10^{-6}/°C$, exhibiting a great difference. Use of a material other than alumina for the insulating layer and of a material other than copper for the heat sink cannot be an essential solution to this problem.

Reference is also made to US—A—3,969,754 which is concerned with a problem in connection with a supporting electrode for a semiconductor substrate. This patent is however silent on the specific problem on the interface between the heat sink and the insulating layer; the semiconductor device does not have an insulating layer.

An object of this invention is to provide a hybrid type integrated circuit device capable of effectively dissipating heat generated in circuit elements.

The invention provides an integrated circuit device according to claim 1.

By use of this invention, the thickness of the insulating layer can be so reduced that the layer has a small thermal resistance, and so it is possible to effectively dissipate heat generated in the circuit elements. Therefore, the difficulties which would otherwise be caused by poor heat dissipation characteristics can be obviated. In addition, the circuit elements being free from risk of overheating permit the conduction of a larger amount of current in devices of the invention than in the prior art device.

In accordance with this invention, the heat sink takes the form of the composite structure wherein fibers of low thermal expansion are embedded in the thermally conductive metal matrix, because this layer can have, because of its composite structure, both the properties of good heat conduction and low thermal expansion. The thermally conductive metal for the matrix is preferably selected from copper, silver, or an alloy mainly containing at least one of copper and silver. Graphite, carbon, tungsten or silicon carbonate may be used for the fiber. Most preferably, graphite or carbon is used which is easy to make into a composite with copper or silver and which can avoid the creation of reactive substances in the composite structure which impair mechanical strength and thermal and electrical conductivity.

Embodiments of this invention will be now described in conjunction with the accompanying drawings, in which:

Fig. 1 is a schematic sectional view of a hybrid type integrated circuit device in accordance with a first embodiment of the invention;

Figs. 2A to 2D and Figs. 3 to 5 are plan views showing examples of fiber patterns in the heat sink in devices in accordance with the invention;

Fig. 6 is a schematic sectional view of another embodiment in accordance with the invention; and

Fig. 7 is a graph showing the relation between the thickness of insulating layer and the blocking voltage.

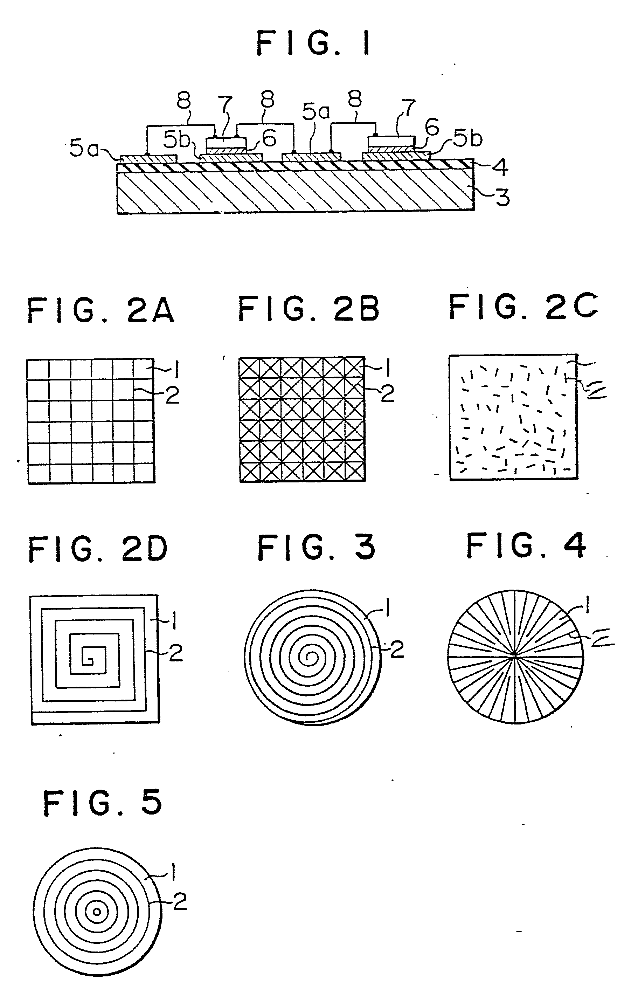

Referring to Fig. 1, there is shown a hybrid type integrated circuit device in accordance with a first embodiment of the invention which comprises a heat sink 3, an insulating layer 4 of alumina disposed on the heat sink 3, a conductor film 5 formed on the insulating layer 4 and including copper films 5a and silver films 5b, and circuit elements interconnected to form a desired circuit network above the conductor film. Each of the circuit elements includes a semiconductor element 7 disposed on a layer 6 of a chromium-nickel-silver alloy and a lead wire 8. Thus, the semiconductor element 7 is disposed above the silver conductor film 5b with interposition of the chrominum-nickel-silver alloy layer 6 therebetween and is connected with the copper conductor film 5a by means of the lead wire 8 of copper. The insulating layer 4 is 100 $\mu$m thick.

The device of this embodiment was fabricated via the following steps.

To form the heat sink, carbon fibers of a diameter of several $\mu$m plated with copper were netted into a sheet and a plurality of the sheets were stacked and hot-pressed at about 800°C in a nitrogen atmosphere. This composite structure contained an average amount of carbon fibers of 30% by volume and exhibited an average thermal expansion coefficient of $9 \times 10^{-6}$/°C within the range from room temperature to 300°C. It will be appreciated that when compared with the thermal expansion coefficient of alumina (about $6.3 \times 10^{-6}$/°C) and the thermal expansion coefficient of copper (about $17 \times 10^{-6}$/°C), the average thermal expansion coefficient is far from the thermal expansion coefficient of copper but close to that of alumina.

Next, onto a major surface of the thus prepared copper-carbon composite structure which was 500 $\mu$m thick and of a square configuration of about 25 mm lateral length alumina was flame-sprayed by a plasma process. The flame spraying of alumina was conducted by subjecting a powder of alumina of 5 $\mu$m average grain size to a plasma jet. in an argon (5 to 15% by volume)-helium atmosphere under the conditions of 800 A current and 2 kg/hr rate. The insulating layer thus prepared exhibited a blocking voltage of 2500 V.

Copper and silver were vapor deposited on the thus prepared insulating layer to form copper and silver conductor films of 10 $\mu$m thickness in a desired pattern, films of chromium-nickel-silver alloy of 1 $\mu$m thickness were formed on the silver conductor films by vapor deposition, semiconductor elements were bonded to the chromium-nickel-silver alloy films by soldering with lead-tin-silver alloy, and the semiconductor elements were connected with the copper conductor films by means of lead wires. The semiconductor elements used herein may include various types of thyristor, transistor and diode. Between electrodes of the semiconductor elements or between electrodes of the semiconductor elements and the conductor film are connected resistors, capacitors and other circuit elements for driving the semiconductor elements.

In this embodiment, the fibers in the composite structure are concentrated in the side thereof contiguous to the insulating layer for the following reasons. Ideally that the heat sink has a thermal expansion coefficient substantially equal to that of the insulating layer. In order to approximate the thermal expansion coefficient of the composite structure to that of the insulating layer, incorporation of a fairly large amount of fibers is required which would be attained at the cost of degradation in thermal conductivity because the thermal conductivity of the fiber is lower than that of the metal matrix. To minimize the degradation in thermal conductivity and at the same time to prevent breakdown of the insulating layer, the fibers are desirably localized in the side of composite structure contiguous to the insulating layer, as in this embodiment. Specifically, the fibers were present 45 vol. % in the side of the heat sink contiguous to the insulating layer and 15 vol. % in the opposite side.

In addition to the above consideration for the purpose of preventing a local thermal distortion at the interface between the heat sink and the insulating layer, which would tend to break or deform the insulating layer, it is preferable to pattern the fibers in the surface of the composite structure contiguous to the insulating layer in such a manner that the thermal expansion of the composite layer is the same in two dimensions. To this end, the fibers are netted and stacked in the thermally conductive metal matrix as in the foregoing embodiment, or sheets of netted fibers are coated with thermally conductive metal and stacked and assembled together. In this case, a pattern as shown in Fig. 2A or 2B may be obtained. Another way is to cut fibers at a suitable length and to embed the cut fibers 2 in the thermally conductive metal matrix 1 in random directions as shown in Fig. 2C. Still another way is to wind a fiber coated with thermally conductive metal in a spiral form and then a plurality of such fibers are press-bonded and assembled together, thereby obtaining a pattern as shown in Fig. 2D or Fig. 3.

Many other patterns of the fibers are possible such as a radial arrangements of the fibers as shown in Fig. 4 and an annular arrangement of the fibers as shown in Fig. 5. Of these patterns, those of Figs. 3 to 5 are suitably adapted to a circular or circle-like heat sink, and those of Figs. 2A, 2B and 2D are suitably adapted to a rectangular or rectangle-like heat sink.

The amount of the fibers in the heat sink is preferably different in the side of the heat sink contigous to the insulating layer and in the opposite side and it depends on what material is used for the insulating layer. Experimental experience shows, however, that an average amount of 15 to 40% by volume is satisfactory.

Alumina ($Al_2O_3$) is preferably used as the material for the insulating layer as being relatively inexpensive and not poisonous. Silicon dioxide ($SiO_2$), boron nitride (BN) or beryllium oxide (BeO) may alternatively be used. Silicon dioxide is useful since it can be as thin as several $\mu$m while exhibiting a high blocking voltage of about 1000 V/$\mu$m. Beryllium oxide has a large thermal conductivity of about 0.07 W/°C which can be useful.

The insulating layer is formed by the flame spray process or alternatively, a previously treated thin plate may be used as the insulating layer. In formation by flame spraying, the material for the insulating layer can advantageously be bonded directly to the heat sink and this manner of formation is suited for mass production. Also, a thin insulating layer can readily be obtained. Disadvantageously, however, voids tend to occur in the insulating layer formed by the flame spray process, thereby increasing thermal resistance or decreasing blocking voltage. An insulating layer in the form of the previously treated thin plate is expected to be of high quality but is not so suited for mass production at the insulating layer formed by the flame spray process. Accordingly, either an insulating layer formed by the flame spray process or an insulating layer in the form of a previously treated thin plate may be selectively used in accordance with the intended purposes.

The insulating layer formed by the flame spray process has preferably a thickness of not less than 50 $\mu$m. An insulating layer of a thickness of less than 50 $\mu$m tends to have reduced blocking voltage. The upper limit of the thickness (irrespective of the fact that the insulating layer is formed by flame spray process or not) is preferably less than 300 $\mu$m to ensure that the thermal resistance can be suitably low.

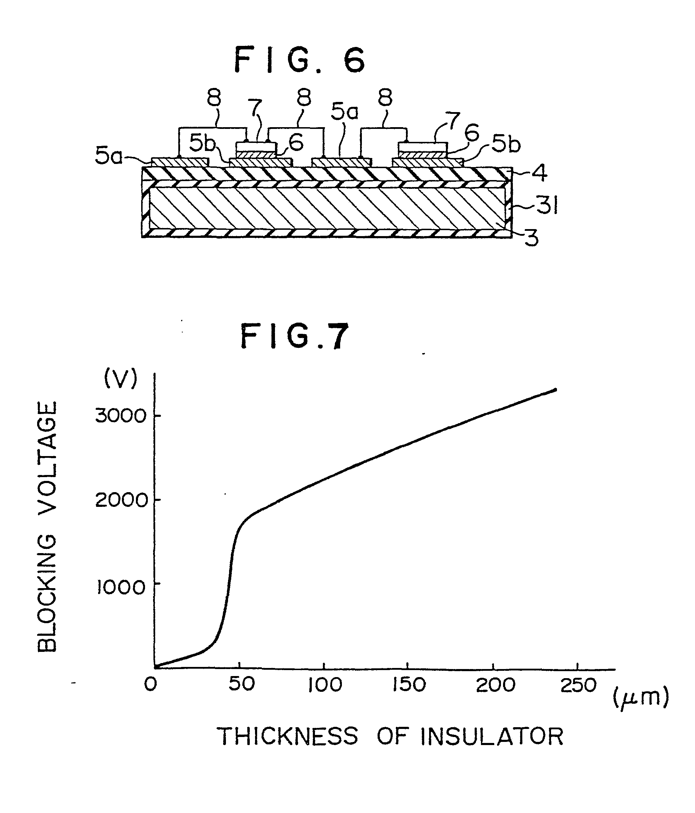

A second embodiment of the invention will be described with reference to Fig. 6 in which the same members as those in Fig. 1 are designated by the same characters. A heat sink 3 was the same as that of the first embodiment. As insulating layer 4, an alumina sintered plate of 250 $\mu$m thickness was used. The whole surface of the heat sink 3 was coated with a thin film of copper oxide (CuO or $Cu_2O$) 31 and the insulating layer 4 was superimposed on the heat sink 3. The insulating layer and heat sink were then bonded together directly by applying a high voltage of about 2000 V across them. This method advantageously simplifies the fabrication process.

Preparation of the heat sink and insulating layer and the manner of bonding these members together have been described by way of examples in the foregoing but they may be achieved in other ways than the above. For example, the heat sink and the insulating layer may be bonded together by diffusion bonding.

The following table shows the characteristics of samples fabricated in accordance with teachings of the invention in comparison with a sample of the prior art. The samples of the invention were fabricated in accordance with the first embodiment and the prior art sample was an integrated circuit device having a heat sink of copper and an alumina sintered plate of 500 $\mu$m thickness bonded to one surface of the heat sink in a similar manner to the second embodiment.

TABLE

| Samples | | Thermal expansion coefficient of heat sink | Blocking voltage of insulating layer | Total thermal resistance |
|---|---|---|---|---|
| This invention | Average amount of fibers 30% | $9 \times 10^{-6}$/°C | 2,500 V | 0.8°C/W |
| | Average amount of fibers 40% | $7 \times 10^{-6}$/°C | 2,500 V | 0.9°C/W |
| Prior art | | $17 \times 10^{-6}$/°C | 4,000 V | 1.7°C/W |

As will be seen from the above table, the samples of the invention were reduced in thermal resistance by about $\frac{1}{2}$ as compared with the prior art sample and had improved heat dissipation characteristics. Therefore, the permissible current conduction in the semiconductor elements was increased. Values of blocking voltage were sufficient for practical use. The insulating layer did not break.

Fig. 7 shows blocking voltages of an insulating layer formed by flame spray process in accordance with the first embodiment when the thickness of the insulating layer is varied. As shown, for a thickness less than 50 $\mu$m, the blocking voltage decreases rapidly and is therefore unsatisfactory. It is also noted that the blocking voltage varies greatly when the thickness varies within the range of less than 50 $\mu$m.

## Claims

1. A hybrid type integrated circuit device comprising a heat sink, an insulating layer bonded to one major surface of said heat sink, metal conductor films disposed on said insulating layer in a desired pattern, and circuit elements connected between said metal conductor films to constitute the desired circuit, characterised in that, the heat sink has a composite structure comprising a thermally conductive metal matrix and fibres embedded in the thermally conductive metal matrix, the fibres having a coefficient of thermal expansion substantially equal to or lower than that of the material of the insulating layer.

2. An integrated circuit device according to claim 1 wherein the said insulating layer is between 50 $\mu$m and 300 $\mu$m thick.

3. An integrated circuit device according to claim 1 or claim 2, wherein said thermally conductive metal matrix consists essentially of one metallic material selected from the group consisting of copper, silver, and an alloy mainly containing at least one of copper and silver.

4. An integrated circuit device according to any one of the preceding claims, wherein said fiber consists essentially of at least one material selected from the group consisting of graphite, carbon, tungsten, and silicon carbonate.

5. An integrated circuit device according to any one of the preceding claims wherein said insulating layer consists essentially of at least one material selected from the group consisting of alumina ($Al_2O_3$), silicon dioxide ($SiO_2$), boron nitride (BN), and beryllium oxide (BeO).

6. An integrated circuit device according to claim 5 wherein said insulating layer comprises a flame spray coating formed on said supporting plate.

7. An integrated circuit device according to claim 5, wherein said insulating layer comprises a thin sintered plate bonded to said supporting plate.

8. An integrated circuit device according to any one of the preceding claims wherein said fibers in the side of said supporting plate contiguous to said insulating layer have homogeneous thermal expansion characteristics.

9. An integrated circuit device according to any one of the preceding claims wherein said circuit elements comprise thyristors and/or transistors.

10. An integrated circuit device according to any one of the preceding claims wherein the fibers are concentrated in a portion of said supporting plate close to said insulating layer.

## Patentansprüche

1. Hybride integrierte Schaltungsanordnung mit einem Kühlkörper, einer mit einer Hauptfläche des Kühlkörpers verbundenen Isolierschicht, auf der Isolierschicht in einem gewünschten Muster angeordneten metallischen Leiterfilmen, sowie zwischen die metallischen Leiterfilme eingeschalteten Schaltungselementen zur Bildung der gewünschten Schaltung, dadurch gekennzeichnet, daß der Kühlkörper eine Verbundstruktur mit einer wärmeleitfähigen Metallmatrix und in der wärmeleitfähigen Metallmatrix eingebetteten Fasern aufweist, wobei die Fasern einen Wärmeausdehnungskoeffizient haben, der im wesentlichen gleich oder geringer ist als derjenige des Materials der Isolierschicht.

2. Integrierte Schaltungsanordnung nach Anspruch 1, wobei die Isolierschicht zwischen 50 $\mu$m und 300 $\mu$m dick ist.

3. Integrierte Schaltung nach Anspruch 1 oder 2, wobei die wärmeleitfähige Metallmatrix im wesentlichen aus einem metallischen Material besteht, das aus der Gruppe ausgewählt ist, die aus Kupfer, Silber und einer hauptsächlich mindestens eines der Elemente Kupfer und Silber enthaltenden Legierung besteht.

4. Integrierte Schaltungsanordnung nach einem der vorhergehenden Ansprüche, wobei die Faser im wesentlichen aus mindestens einem Material besteht, das aus der aus Graphit, Kohlenstoff, Wolfram und Siliziumcarbonat bestehenden Gruppe ausgewählt ist.

5. Integrierte Schaltungsanordnung nach einem der vorhergehenden Ansprüche, wobei die Isolierschicht im wesentlichen aus mindestens einem Material besteht, das aus der aus Aluminiumoxid ($Al_2O_3$), Siliziumdioxid ($SiO_2$), Bornitrid (BN) und Berylliumoxid (BeO) bestehenden Gruppe ausgewählt ist.

6. Integrierte Schaltungsanordnung nach Anspruch 5, wobei die Isolierschicht eine auf der Trägerplatte ausgebildete Flammenspritzbeschichtung enthält.

7. Integrierte Schaltungsanordnung nach Anspruch 5, wobei die Isolierschicht eine mit der Trägerplatte verbundene dünne gesinterte Platte enthält.

8. Integrierte Schaltungsanordnung nach einem der vorhergehenden Ansprüche, wobei die Fasern in der an die Isolierschicht angrenzenden Seite der Trägerplatte homogene Wärmeausdehnungseigenschaften aufweisen.

9. Integrierte Schaltungsanordnung nach einem der vorhergehenden Ansprüche, wobei die Schaltungselemente Thyristoren und/oder Transistoren umfassen.

10. Integrierte Schaltungsanordnung nach einem der vorhergehenden Ansprüche, wobei die Fasern in einem der Isolierschicht nahen Teil der Trägerplatte konzentriert sind.

## Revendications

1. Circuit intégré du type hybride comprenant un dissipateur thermique, une couche isolante liée à une surface majeure dudit dissipateur thermique, des pellicules conductrices en métal disposées sur ladite couche isolante selon un motif souhaité et des éléments de circuit connectés entre lesdites pellicules conductrices en métal pour constituer le circuit souhaité, caractérisé en ce que le dissipateur thermique a une structure composite qui comprend une matrice métallique thermiquement conductrice et des fibres noyées dans la matrice métallique thermiquement conductrice, les fibres ayant un coefficient de dilatation thermique sensiblement égal ou plus faible que celui du matériau de la couche isolante.

2. Circuit intégré selon la revendication 1, où ladite couche isolante a une épaisseur comprise entre 50 $\mu$ et 300 $\mu$.

3. Circuit intégré selon la revendication 1 ou la revendication 2, où la matrice métallique thermiquement conductrice comprend essentiellement un matériau métallique choisi dans le groupe consistant en cuivre, argent et un alliage contenant principalement au moins du cuivre ou de l'argent.

4. Circuit intégré selon l'une quelconque des revendications précédentes où ladite fibre se compose essentiellement d'au moins un matériau choisi dans le groupe consistant en graphite, carbone, tungstène et carbonate de silicium.

5. Circuit intégré selon l'une quelconque des revendications précédentes, où ladite couche isolante se compose essentiellement d'au moins un matériau choisi dans le groupe consistant en alumine ($Al_2O_3$), bioxyde de silicium ($SiO_2$), nitrure de bore (BN) et oxyde de béryllium (BeO).

6. Circuit intégré selon la revendication 5, où ladite couche isolante comprend un revêtement par jet de flamme formé sur ladite plaque de support.

7. Circuit intégré selon la revendication 5, où ladite couche isolante comprend une plaque mince agglomérée liée à ladite plaque de support.

8. Circuit intégré selon l'une quelconque des revendications précédentes, où lesdites fibres sur le côté de ladite plaque de support contigu à ladite couche isolante ont des caractéristiques homogènes de dilatation thermique.

9. Circuit intégré selon l'une quelconque des revendications précédentes, où lesdits éléments de circuit forment des thyristors et/ou des transistors.

10. Circuit intégré selon l'une quelconque des revendications précédentes, où les fibres sont concentrées dans une partie de ladite plaque de support près de ladite couche isolante.

0 009 978

# FIG. 1

# FIG. 2A

# FIG. 2B

# FIG. 2C

# FIG. 2D

# FIG. 3

# FIG. 4

# FIG. 5

1

# FIG. 6

# FIG.7

BLOCKING VOLTAGE (V)

THICKNESS OF INSULATOR (μm)